# EUROPEAN PATENT APPLICATION

(11) **EP 1 940 020 A2**
(43) Date of publication of application: **02.07.2008**
(21) Application number: 07150327.0
(22) Date of filing: 21.12.2007
(51) Int. Cl.: H03F 3/08

(54) **Solid-state imaging element, method of controlling solid-state imaging element, and imaging device**

(30) Priority: 27.12.2006 JP 2006352707; 21.11.2007 JP 2007301972
(71) Applicant: Omron Corporation, Kyoto-shi, Kyoto 600-8530 (JP)
(72) Inventor: Hashimoto, Masashi, c/o Omron Corporation, Kyoto-shi, Kyoto 600-8530 (JP)
(74) Representative: Wilhelms · Kilian & Partner Patentanwälte

(57) **Abstract**

To erase the afterimage. A solid-state imaging element includes an X decoder for generating the reset voltage for resetting the pixel cell, and supplying the reset voltage to every other pixel cells along at least one of the row direction or the column direction during the reset period. The solid-state imaging element also includes Y decoders for separately outputting a first image signal read out from the pixel cells not supplied with the reset voltage and the second image signal read out from the pixel cells supplied with the reset voltage.

## Description

### BACKGROUND OF THE INVENTION

### 1. Field of the Invention

The present invention relates to a solid-state imaging element, a method of controlling the solid-state imaging element, and an imaging device.

### 2. Description of the related art

Conventionally, for example, a solid-state imaging element for generating imaged data by accumulating charges as in a linear conversion type imaging element is known. Such solid-state imaging element must erase (reset) the accumulated charges to generate the imaged data of the next screen due to its configuration. Therefore, there is a limit to having a short imaging interval since all the pixels must be reset for every screen.

A solid-state imaging element having a configuration of constantly detecting voltage in an electrically equilibrium state without accumulating charges as in a logarithmic conversion type imaging element is also known (see e.g., "Basic and Application of CCD/CMOS image sensor" by Kazuya Yonemoto, CQ Publication, 2003, pages. 214-215). An integration time (time for accumulating charges) does not need to be provided as in the charge accumulating type, and the reset operation is not necessary. Therefore, the imaging interval can be reduced.

An optical sensor circuit for discharging the accumulated charges by changing the voltage to be applied to the logarithmic conversion type imaging element and preventing the generation of an afterimage is also known (see Japanese Laid-Open Patent Publication No. 10-90058).

In the non-accumulating type solid-state imaging element, when the subject moves, the light quantity entering the photodiode changes according to such movement, whereby the photocurrent changes and an electrically non-equilibrium state is temporally obtained. In this case, it takes time for the photodiode to return to the equilibrium state, and thus an afterimage in which a bright subject appears as if moving while leaving traces behind is generated

### SUMMARY OF THE INVENTION

The present invention aims to erase the afterimage.

The imaging device according to the present invention includes a solid-state imaging element having an imaging unit in which a pixel cell including a light receiving element and an element for converting a photocurrent flowing to the light receiving element to a voltage under an electrically equilibrium state is arrayed in a matrix form, a voltage generating means for generating a reset voltage for resetting the pixel cell, and a voltage supplying means for supplying the reset voltage to the pixel cell for every predetermined number along at least one of a row direction or a column direction in a reset period; and an output means for separately outputting a first image signal read out from a pixel cell not supplied with the reset voltage and a second image signal read out from a pixel cell supplied with the reset voltage. According to such configuration, the pixel cell supplied with the reset voltage and the pixel cell not supplied with the reset voltage are separately output.

In one aspect of the invention, the imaging device includes the solid-state imaging element; an afterimage determining means for determining whether or not an afterimage is generated in an imaged image based on the first image signal and the second image signal output from the output means; and an afterimage erasing means for erasing the afterimage based on the determination result of the afterimage determining means, the first image signal, and the second image signal. Thus, the afterimage is determined using the afterimage determining means, and the detected afterimage can be erased.

In one aspect of the invention, the afterimage determining means includes contour extracting units for extracting a contour of an imaged image by the first image signal and a contour of an imaged image by the second signal, and a contour comparing unit for comparing the two contours extracted by the contour extracting units, and determines whether or not an afterimage is generated from the comparison result. Thus, a contour image is generated by performing edge reinforcement process etc. in the contour extracting unit, and the afterimage is determined as being generated when there is a shift in the contours of the first image signal and the second image signal.

In one aspect of the invention, the afterimage erasing means includes an interpolation means for generating an interpolated image in which an image signal corresponding to the pixel cell not supplied with the reset voltage is interpolated based on the second image signal; and an image synthesizing means for generating a synthesized image by synthesizing the imaged image by the first image signal and the imaged image by the second image signal; and an output selecting means for outputting the interpolated image generated by the interpolation means when determined that the afterimage is generated in the afterimage determining means, and outputting the synthesized image generated by the synthesizing means when determined that the afterimage is not generated. Thus, the imaged image is obtained using the normal synthesizing means when the afterimage is not generated, and the interpolated image in which the afterimage is erased is obtained using the interpolation means when the afterimage is generated.

In one aspect of the invention, an image synthesizing means for generating a synthesized image by synthesizing the first image signal and the second image signal is further arranged.
In one aspect of the invention, an interpolation means for generating an interpolated image in which an image signal corresponding to the pixel cell not supplied with the reset voltage is interpolated based on the second image signal is further arranged.

A method of controlling the solid-state imaging element according to the present invention is a method of controlling a solid-state imaging element including an imaging unit in which a plurality of pixel cells is arrayed in a matrix form, each pixel cell having a light receiving element and a MOS transistor connected in series, and converting a photocurrent flowing to the light receiving element according to an incident light by operating the MOS transistor in a weak inversion state to a voltage; the method including voltage supplying step for supplying a reset voltage for resetting the pixel cell to the pixel cell for every predetermined number along at least one of row direction or column direction in a reset period; and outputting step for separately outputting a first image signal read out from a pixel cell not supplied with the reset voltage and a second image signal read output from a pixel cell supplied with the reset voltage. According to such steps, the pixel cell supplied with the reset voltage and the pixel cell not supplied with the reset voltage can be separately output. The different image information is compared to check whether or not the afterimage is generated. Even if the afterimage is generated, the image in which the generated afterimage is erased can be generated by generating an interpolated image using the image information acquired under different conditions.

The afterimage can be erased.

### BRIEF DESCRIPTION OF THE DRAWINGS

FIG. 1 shows a block diagram showing an electrical configuration of an imaging device of one embodiment;
FIG. 2 shows a circuit diagram of a pixel cell;
FIG. 3A shows an explanatory view of image data after synthesis;
FIG. 3B shows an explanatory view of image data after interpolation;
FIGS. 4A to 4D show explanatory views of an afterimage generation determining method;
FIG. 5 shows a timing chart showing a control timing of the solid-state imaging element;
FIG. 6 shows a block diagram showing an electrical configuration of another imaging device;
FIG. 7 shows a circuit diagram showing an imaging unit of another solid-state imaging element;
FIG. 8 shows a block diagram showing an electrical configuration of another imaging device;
FIG. 9 shows a circuit diagram showing an imaging unit of another solid-state imaging element;
FIG. 10 shows a timing chart showing a control timing of the solid-state imaging element;
FIG. 11 shows a timing chart showing a control timing of the solid-state imaging element; and

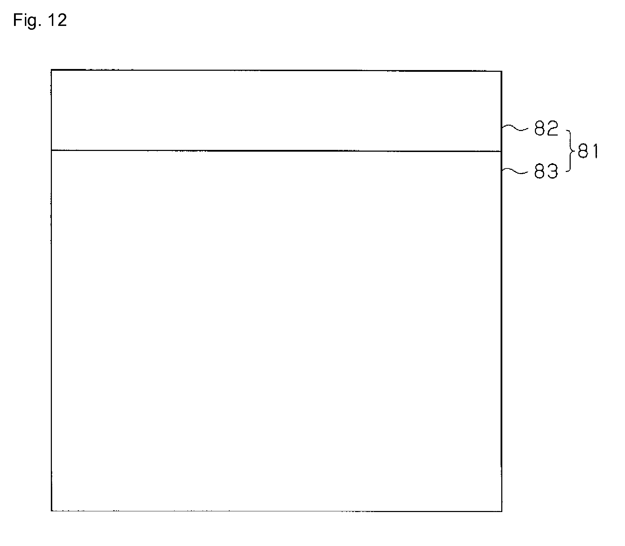

FIG. 12 shows a circuit diagram showing an imaging unit of another solid-state imaging element.

### DETAILED DESCRIPTION OF THE PREFERRED EMBODIMENTS

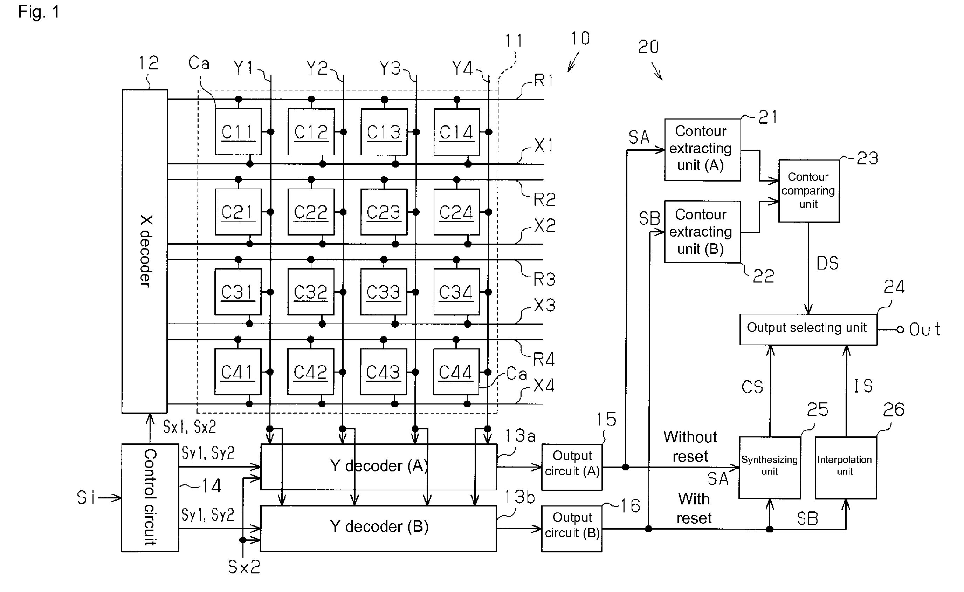

One embodiment embodying the present invention will now be described according to FIG. 1 to FIG. 3.
As shown in FIG. 1, an imaging device is configured by a solid-state imaging element 10 and an image processing section 20. The solid-state imaging element 10 includes an imaging unit 11 surrounded by dotted lines, an X decoder serving as an address decoder, a Y decoder (A) 13a, and a Y decoder (B) 13b, a control circuit 14, and output circuits 15, 16. The image processing section 20 includes a contour extracting unit (A) 21, a contour extracting unit (B) 22, and a contour comparing unit 23 serving as an afterimage determining means, an output selecting unit 24 serving as an output selecting means, a synthesizing unit 25 serving as an image synthesizing means, and an interpolation unit 26 serving as an interpolation means.

The imaging unit 11 includes a plurality of pixel cells Ca arrayed in a matrix form. For the sake of simplifying the description, the imaging unit 11 including pixel cells Ca arrayed in a matrix form of four by four will be described in the present embodiment. Each pixel cell Ca is referred to as C11 to C14, C21 to C24, C31 to C34, and C41 to C44 for positional description.

Each pixel cell Ca has a light receiving element. Each pixel cell Ca detects the current flowing to the respective light receiving element and converts the current to an electrical signal. The pixel cells Ca of each row are connected to the corresponding row signal lines X1 to X4. The pixels cells Ca of each column are connected to the corresponding column data lines Y1 to Y4. Specifically, the pixel cells C11, C12, C13, and C14 are connected to the row signal line X1. Similarly, the pixel cells C21 to C24, C31 to C34, and C41 to C44 are connected to the corresponding signal lines X2 to X4. The pixel cells C11, C21, C31, and C41 are connected to the column data line Y1. Similarly, C12 to C42, C13 to C43, and C14 to C44 are connected to the corresponding column data lines Y2 to Y4.

The pixel cells Ca of each row are connected to the corresponding reset voltage lines R1 to R4. Specifically, the pixel cells C11, C12, C13, and C14 are connected to the reset voltage line R1. Similarly, the pixel cells C21 to C24, C31 to C34, and C41 to C44 are connected to the corresponding rest voltage line R2 to R4. A predetermined exposure potential is constantly applied to the reset voltage lines R1 to R4.

The row signal lines X1 to X4 and the reset voltage lines R1 to R4 are connected to the X decoder 12. The column data lines Y1 to Y4 are connected to the Y decoder (A) 13a and the Y decoder (B) 13b serving as output means. The X decoder 12, the Y decoder (A) 13a and the Y decoder (B) 13b are connected to the control circuit 14.

The control circuit 14 generates a row address signal and a column address signal based on the input address signal Si. The control circuit 14 then provides the row address signal to the X decoder 12. Furthermore, the control circuit 14 provides the column address signal to the Y decoder (A) 13a and the Y decoder (B) 13b. In the present embodiment, the control circuit 14 generates row address signals Sx1, Sx2 of two bits corresponding to the number of rows of the imaging unit 11, and column address signals Sy1, Sy2 of two bits corresponding to the number of columns of the imaging unit 11. The control circuit 14 generates a control signal for driving each pixel cell Ca and the like.

The X decoder 12 includes a voltage control circuit (voltage generating means and voltage supplying means) serving as a power supply for generating a reset voltage and a voltage for reading out the image signal. When the row address signals Sx1, Sx2 of two bits corresponding to the number of rows of the imaging unit 11 are input to the X decoder 12 from the control circuit 14, the X decoder 12 decodes the row address signals Sx1, Sx2 and selects one of the row signal lines X1 to X4. The X decoder 12 then controls the potential of the selected row signal line to the voltage level for reading out the image information from the pixel cell Ca. In the present embodiment, the voltage for reading out the image information is supplied as read-out signal to the four pixel cells Ca connected to the same row signal line. Each pixel cell Ca outputs the image information to the column data lines Y1 to Y4 in response to the read-out signal provided via the row signal lines X1 to X4.

The X decoder 12 constantly applies the predetermined exposure potential to the reset voltage lines. In response to the control signal, the X decoder 12 sequentially supplies the reset voltage for every other reset voltage lines (reset voltage lines R2, R4 of even row in the present embodiment) (voltage supplying step). The pixel cells Ca (C21 to C24, C41 to c44) connected to the reset voltage lines R2, R4 supplied with the reset voltage reset the sense node by the supplied reset voltage. The sense node will be hereinafter described.

The column address signals Sy1, Sy2 are input to the Y decoder (A) 13a and the Y decoder (B) 13b. The Y decoder (A) 13a and the Y decoder (B) 13b select the column data lines Y1 to Y4 based on the column address signals Sy1, Sy2. The Y decoder (A) 13a and the Y decoder (B) 13b respectively has a function of amplifying the image information input via each column data line Y1 to Y4, and converting the amplified signal to a digital signal.

The row address signal Sx2 of low order is also input to the Y decoder (A) 13a and the Y decoder (B) 13b. The Y decoder (A) 13a outputs a first image signal converted from the image information read out from the pixel cells Ca (C11 to C14, C31 to C34) of odd rows to the output circuit (A) 15 based on the row address signal Sx2 (outputting step). The Y decoder (B) 13b outputs a second image signal converted from the image information read out from the pixel cells Ca (C21 to C24, C41 to C44) of even rows to the output circuit (B) 16 based on the row address signal Sx2 (outputting step).

As described above, the X decoder 12 does not supply the reset voltage to the pixel cells Ca (C11 to C14, C31 to C34) of odd rows but supplies the reset voltage to the pixel cells Ca (C21 to C24, C41 to C44) of even rows in the imaging unit 11. Therefore, the Y decoder (A) 13a outputs the first image signal that is not reset, and the Y decoder (B) 13b outputs the second image signal that is reset every predetermined time.

The output circuit (A) 15 outputs a first image signal SA output from the Y decoder (A) 13a to the contour extracting unit (A) 21 and the synthesizing unit 25. The output circuit (B) 16 outputs a second image signal SB output from the Y decoder (B) 13b to the contour extracting unit (B) 22, the synthesizing unit 25, and the interpolation unit 26.

The contour extracting unit (A) 21 performs image processing (e.g., edge reinforcement) on the imaged image (first imaged image) configured by the first image signal SA and extracts the contour, and then outputs first contour data to the contour comparing unit 23. The contour extracting unit (B) 22 performs image processing (e.g., edge reinforcement) on the imaged image (second imaged image) configured by the second image signal SB and extracts the contour, and then outputs second contour data to the contour comparing unit 23.

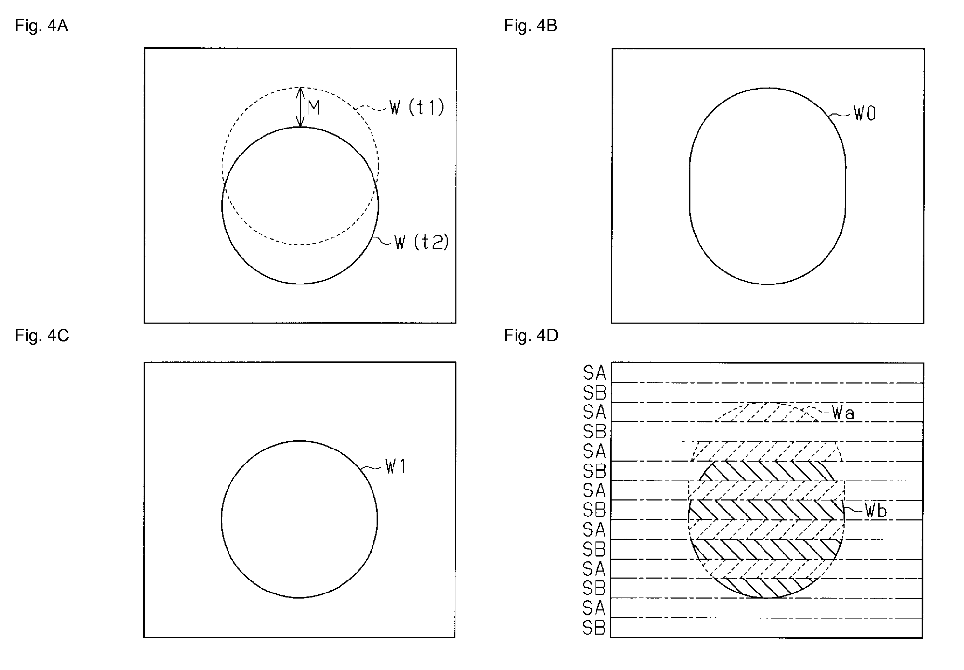

The contour comparing unit 23 calculates the difference based on the first contour data and the second contour data extracted by the contour extracting unit (A) 21 and the contour extracting unit (B) 22, respectively. Determination is then made on whether or not an afterimage is generated based on the calculated difference. Consider a case where a circular object W having high luminance moves by distance M along a direction coinciding with an up and down direction in FIG. 1. Such state is shown in FIG. 4A. In FIG. 4A, the object W (t1) before moving is shown with a broken line. The object W (t2) after moving is shown with a solid line.

The object W that moves in such manner is imaged by the imaging element. In the imaging device in which all the pixel cells are not reset, the moving object W is photographed as an oval object W0, as shown in FIG. 4B. In the imaging device in which all the pixel cells are reset, the object is photographed as a circular object W1, as shown in FIG. 4C. Therefore, in the present embodiment, the first image signal SA obtained by photographing the object WO shown in FIG. 4B at the pixel cells Ca not supplied with the reset voltage, and the second image signal SB obtained by photographing the object W1 shown in FIG. 4C at the pixel cells Ca supplied with the reset voltage are generated.

FIG. 4D shows the image of the first image signal SA and the image of the second image signal SB shifted according to the position of the pixel cells that photographed the corresponding image. As shown in FIG. 4D, a difference is created between the contour Wa of the object W in the first image signal SA shown with a broken line and the contour Wb of the object W in the second image signal SB shown with a solid line. Therefore, determination is made on whether or not an afterimage is generated based on a fact that a difference is created between the contours Wa, Wb. According to the comparison result, the contour comparing unit 23 outputs a comparison result signal DS of H level when afterimage is generated and the comparison result signal of L level when afterimage is not generated to the output selecting unit 24.

The output selecting unit 24 selects an output signal from the synthesizing unit 25 or an output signal from the interpolation unit 26 according to the comparison result signal DS. The output selecting unit 24 externally outputs the selected signal as an image signal Out.

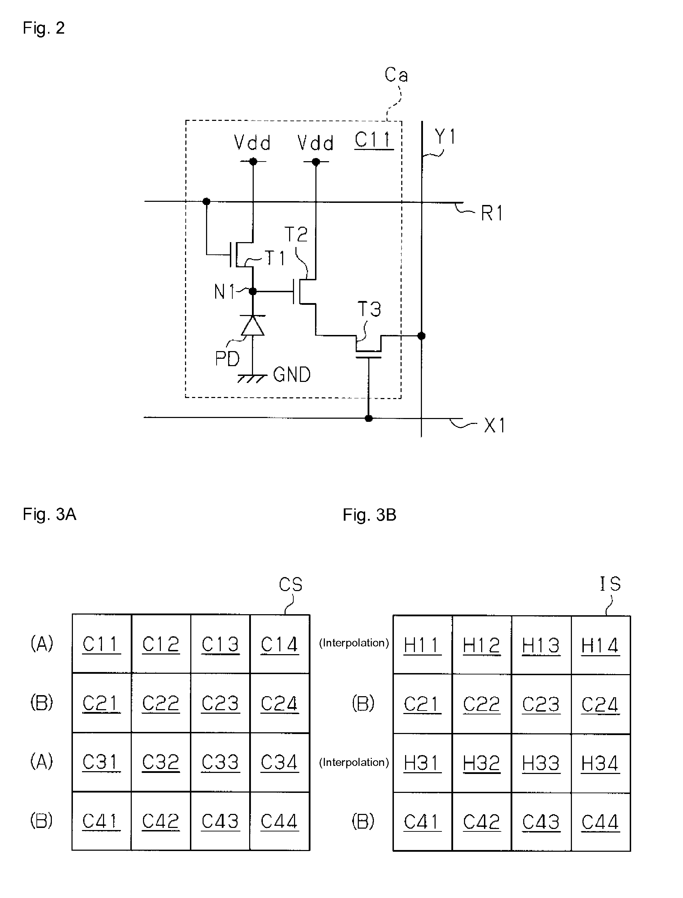

The synthesizing unit 25 synthesizes the first image signal SA without rest output from the output circuit 15 and the second image signal SB with reset output from the output circuit 16, and outputs a synthesized image CS for one screen. The first image signal SA is the image information output from the pixel cells Ca of odd rows of the imaging unit 11, and the second image signal SB is the image information output from the pixel cells Ca of even rows of the imaging unit 11. As shown in FIG. 3A, the synthesizing unit 25 generates the synthesized image CS configured by the image information output from all the pixel cells Ca of the imaging unit 11.

The interpolation unit 26 generates the image signal of the position not included in the second image signal SB through interpolation based on the second image signal SB output from the Y decoder (B) 13b. The image signal of the position not included in the second image signal SB is the image signal equivalent to the image signal output from the pixel cells Ca (C11 to C14, C31 to C34) of odd rows. A linear interpolation etc. is used for the interpolation method. As shown in FIG. 3B, the interpolation unit 26 generates image information of a corrected pixel H31 interpolated between the pixel cells C21, C41 based on the image information read out from the pixel cell C21 and the image information read out from the pixel cell C41. For instance, calculation is performed based on an equation for linear interpolation as expressed by H31=(C21 +C41)/2. The interpolation unit 26 similarly generates image information of corrected pixels H32 to H34. The interpolation unit 26 also generates image information of a corrected pixel H11 extrapolated from the pixel cells C21, C41. The interpolation unit 26 similarly generates image information of corrected pixels H12 to H14. The interpolation unit 26 then generates an interpolated image IS configured by the image information of the pixel cells C21 to C24, C41 to C44, and the interpolated pixels H11 to H14, H41 to H34.

FIG. 2 is a circuit diagram showing a pixel cell Ca of the solid-state imaging element 10. Since the configuration of each pixel cell Ca is the same in the solid-state imaging element 10, the configuration of one pixel cell Ca (pixel cell C11) will be described herein.

The pixel cell Ca is configured by a photodiode PD serving as a light receiving element, and three transistors T1 to T3. The first to third transistors T1 to T3 are MOS transistors of a first conductivity channel type. Although not shown, back gates of the MOS transistors are all connected to the ground GND. In the present embodiment, the description is made with the N-channel MOS transistor used for the first to third transistors.

The drain (first terminal) of the first transistor T1 serving as a load transistor is connected to the high potential power supply Vdd. The gate (control terminal) of the first transistor T1 is connected to the reset voltage line R1. The source (second terminal) of the first transistor T1 is connected to the cathode of the photodiode PD. The anode of the photodiode PD is connected to the low potential power supply (ground GND in the present embodiment). The photodiode PD flows a current Ip corresponding to the light quantity of the incident light.

A sense node N1, which is a connecting point of the first transistor T1 and the photodiode PD, is connected to the gate of the second transistor T2 serving as an amplifier transistor. The drain of the second transistor T2 is connected to the high potential power supply Vdd. The source of the second transistor T2 is connected to the first terminal (e.g., drain) of the third transistor T3 serving as a pixel selecting transistor.

The gate of the third transistor T3 is connected to the row signal line X1. The second terminal (source) of the third transistor T3 is connected to the column data line Y1. The third transistor T3 is ON/OFF operated in response to the read-out signal provided via the row signal line X1. The second transistor T2 and the column data line Y1 are electrically connected or electrically separated according to the ON/OFF operation of the third transistor T3. Accordingly, the second transistor T2 and the column data line Y1 are connected when the third transistor T3 is turned ON. A constant current power supply (not shown) is connected to the column data line Y1, which constant current source configures a source follower circuit with the second transistor T2, and the potential of the sense node N1 is output to the column data line Y1 as a photoelectric conversion signal via the second transistor T2.

When light hits the pixel cell Ca configured as above, the current of the same amount as the current (photocurrent) flowing to the photodiode PD according to the quantity of light flows to the first transistor T1, and the sense node N1 stabilizes to the potential corresponding thereto (electrically equilibrium state). Since the first transistor T1 operates in a weak inversion region, the potential at the sense node N1 becomes the potential obtained by logarithmic converting the photocurrent flowing to the photodiode PD. The third transistor T3 is turned ON when the read-out signal is applied to the row signal line X1, and the photoelectric conversion signal of the potential corresponding to the quantity of incident light at the sense node N1 is output to the column data line Y1.

When the object W of high luminance moves, the quantity of light entering the photodiode PD changes according to such movement. The current flowing to the photodiode PD then changes by such change, and temporarily becomes an electrically non-equilibrium state. In this case, it takes time for the photodiode PD to return to the electrically equilibrium state.

The current flowing in proportion to the quantity of light entering the photodiode PD is accumulated in the capacitor as light charges in the solid-state imaging element 10. An equivalent capacitor combined with a floating capacity formed by the photodiode PD, the first transistor T1, the second transistor T2 and the wiring for connecting such components to each other, a capacitor formed through a semiconductor manufacturing process, or the like are connected as a capacitor.

The amount of charge accumulated in the capacitor is converted to an electrical signal and read out as an image signal. The charges accumulated in the capacitor remain un-erased even if converted to the electrical signal. The accumulated charges are maintained as it is unless the luminance of the object W changes. The current flowing to the photodiode decreases when the luminance of the object W lowers. Accordingly, the charges accumulated in the capacitor also decrease. However, decrease in charges is not instantaneous but is gradual. The gradual decrease appears on the imaged image as decrease in the form of afterimage. The time required for gradual decease becomes longer the lesser the current flowing to the photodiode, that is, the darker the imaged image.

Therefore, when a bright light is entering until immediately before and the bright light suddenly stops entering, that is, when suddenly becomes dark, it takes a long time for the charges accumulated in the capacitor to decrease in the pixel cell Ca that is not reset. In other words, the afterimage is generated significantly.

The charges accumulated in the capacitor of the pixel cell Ca can be electrically erased and initialized to obtain a dark state by resetting the pixel cell Ca. In other words, the charges accumulated in the previous imaged frame are erased. As there is no influence of the previous imaged frame, the afterimage does not generate.

The potential of the sense node N1 becomes a predetermined potential by resetting the pixel cell Ca. Applying a predetermined potential to the sense node N1 is having the pixel cell Ca in the reset state. After the reset, the potential of the sense node N1 is maintained at the potential based on the charges accumulated according to the current flowing to the photodiode PD.

When resetting the pixel cell Ca, higher potential is applied to the first transistor T1 through the gate the greater the change from the weak inversion region to the strong inversion region to be completely turned ON. Thus, in a state the operation voltage (normal exposure potential) for the first transistor T1 to be in the weak inversion region is applied in advance, the reset voltage for raising such potential is applied via the reset voltage line R1. In the first transistor T1 in the strong inversion state, the drain current flowing from the drain to the source becomes saturated, the sense node N1 cannot maintain the electrically equilibrium state even when the current corresponding to the quantity of light of the photodiode PD is flowed, and as a result, the sense node N1 becomes the reset state.

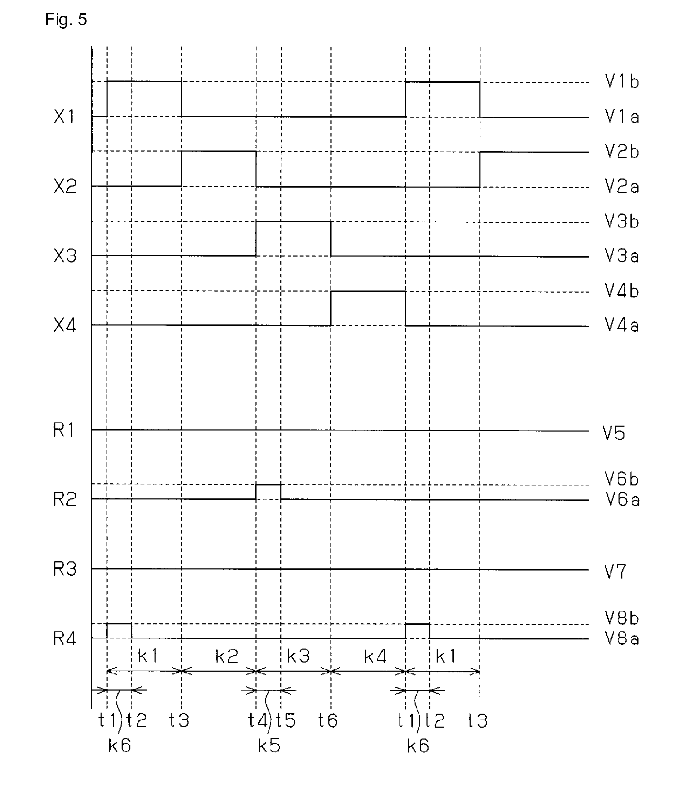

The operation of the imaging device configured as above will now be described.
First, the operation of the solid-state imaging element 10 will be described according to FIG. 5.
The potential to be applied to the row signal line X1 is raised from potential V1a to potential V1 b in a read-out period k1 of the row signal line X1 from time t1 to time t2. The image signal is accordingly output to the column data lines Y1 to Y4. Similarly, the potential to be applied to the row signal line X2 is raised from potential V2a to potential V2b in a read-out period k2 of the row signal line X2 from time t2 to time t4. The image signal is accordingly output to the column data lines Y1 to Y4. The potential to be applied to the row signal line X3 is raised from potential V3a to potential V3b in a read-out period k1 of the row signal line X3 from time t4 to time t5. The image signal is accordingly output to the column data lines Y1 to Y4. The potential to be applied to the row signal line X4 is raised from potential V4a to potential V4b in a read-out period k4 of the row signal line X4 from time t5 to time t1, which is the start of the next cycle. The image signal is accordingly output to the column data lines Y1 to Y4. In the present embodiment, the potential to be applied to such column data lines is 0V when the potential is not applied, and 3.3V when the potential is applied. Furthermore, the timing of applying the potential to each row signal line X1 to X4 is repeatedly given at a cyclic order.

The manner of applying the reset voltage in the relevant time chart will be described below. At time t3, the voltage is applied to the row signal line X2 for selecting the even pixel cells, and the exposure of the pixel cells Ca (e.g., pixel cell arrangement C21 to C24) of the relevant column starts. When the exposure of the pixel cells Ca is terminated at time t4, the reset voltage is applied to the reset voltage line R2 before the next exposure starts from after the relevant time. The reset voltage is applied to the reset voltage line R2 during the reset period k5 of reset operating the pixel cells Ca connected to the row signal line X2 from time t4 to time t5. The image signal is accordingly output to the column data lines Y1 to Y4. The reset voltage applied in this case is a potential V6b (greater than or equal to 3.5V in FIG. 5) higher than V6a (same potential as V2b) which is the normal exposure potential. Similarly, the potential V8b higher than the potential V8a normally applied to the reset voltage line R4 is applied as the reset voltage during the reset period k6 of the row signal line X4 from time t1 to time t2. The image signal is accordingly output to the column data lines Y1 to Y4.

The timing of applying such reset voltages is also repetitive and cyclic that accords with each row signal line X1 to X4. The reset voltage lines R1, R3 that do not perform the reset operation are normally applied with the normal exposure potential of V5, V7 on a constant basis.

The operation of the image processing section 20 will now be described.
The first image signal SA and the second image signal SB based on the image information read out from the pixel cells Ca of the imaging unit 11 are input to the image processing section 20. The contour extracting unit (A) 21 and the contour extracting unit (B) 22 of the image processing section 20 extract the contour of the imaged image by the first image signal SA and the second image signal SB, respectively, and the contour comparing unit 23 compares the contours of both image signals and outputs the comparison result signal DS corresponding to the comparison result.

The synthesizing unit 25 generates the synthesized image CS for one screen based on the first image signal SA and the second image signal SB.
The interpolation unit 26 generates the image information of the interpolated pixel based on the second image signal SB, and outputs the interpolated image IS configured by the image information of the pixel cells Ca by the second image signal SB and the image information of the interpolated pixels. The second image signal SB is a signal output from the pixel cells Ca (C21 to c24, C41 to C44) supplied with the reset voltage, and thus the second image signal SB to be output from the interpolation unit 26 does not contain afterimage. That is, the interpolation unit 26 configures an afterimage erasing means for erasing the afterimage based on the second image signal SB.

In response to the comparison result signal DS, the output selecting unit 24 selects the synthesized image CS and outputs the same to the outside as the image signal Out if the afterimage is not generated, and selects the interpolated image IS and outputs the same to the outside as image signal Out if the afterimage is generated.

The present embodiment has the following advantages.
(1) The solid-state imaging element 10 includes the X decoder 12 for generating the reset voltage for resetting the pixel cells Ca, and supplying the reset voltage to every other pixel cells Ca along at least one of the row direction or the column direction during the reset period. The solid-state imaging element 10 also includes the Y decoder (A) 13a and the Y decoder (B) 13b for outputting the first image signal SA read out from the pixel cells Ca (C11 to C14, C31 to C34) not supplied with the reset voltage and the second image signal SB read out from the pixel cells Ca (C21 to C24, C41 to C44) supplied with the reset voltage. According to such configuration, the pixel cells supplied with the reset voltage and the pixel cells not supplied with the reset voltage can be separately output. The different image information is compared to check whether the afterimage is generated. Even if the afterimage is generated, an image in which the generated afterimage is erased can be generated by generating the interpolated image using the image information acquired under different conditions.

(2) The contour comparing unit 23 receives results from the contour extracting unit (A) 21 and the contour extracting unit (B) 22 for extracting the contour of the corresponding image signal based on the first image signal SA and the second image signal SB output from the solid-state imaging element 10, and determines whether or not an afterimage is generated in the imaged image. On the basis of the determination result of the contour comparing unit 23, the synthesizing unit 25 for erasing the afterimage based on the first image signal SA and the second image signal SB generates the synthesized image CS in which the first image signal SA and the second image signal SB are synthesized. The interpolation unit 26 is configured to generate the interpolated image IS using the second image signal SB and the generated interpolation thereof, and is able to erase the afterimage.

(3) Configuration is made by the contour extracting unit (A) 21 and the contour extracting unit (B) 22 for extracting the contour Wa of the imaged image by the first image signal SA and the contour Wb of the imaged image by the second image signal SB, respectively, and the contour comparing unit 23 for comparing the two contours Wa, Wb extracted by the contour extracting unit (A) 21 and the contour extracting unit (B) 22, where determination is made on the afterimage from the comparison result obtained by the contour comparing unit 23. Thus, edge reinforcement etc. is performed in the contour extracting units 21, 22 to generate a contour image, and determination is made that an afterimage is generated when there is a shift in contours between the first image signal SA and the second image signal SB.

(4) The imaging device includes the interpolation unit 26 for generating the interpolated image IS configured by the second image signal SB and the interpolation data H11 to H14, H31 to H34 interpolating the pixel cells Ca (C21 to c24, C41 to C44) from which the second image signal is read out. The imaging device also includes the synthesizing unit 25 for synthesizing the imaged image by the first image signal SA and the imaged image by the second image signal SB to generate the synthesized image CS. The imaging device further includes the output selecting unit 24 for outputting the interpolated image IS generated by the interpolation unit 26 when determined that the afterimage is generated and outputting the synthesized image generated by the synthesizing unit 25 when determined that the afterimage is not generated. Thus, the imaged image is obtained using the normal synthesizing unit 25 when the afterimage is not generated, and the interpolated image in which the afterimage is erased is obtained using the interpolation unit 26 when the afterimage is generated.

(5) The solid-state imaging element 10 includes the X decoder 12 for generating the reset voltage for resetting the pixel cell Ca, and supplying the reset voltage to every other pixel cell Ca along at least one of the row direction or the column direction during the reset period. The solid-state imaging element 10 controls the Y decoder (A) 13a and the Y decoder (B) 13b to separately output the first image signal read out from the pixel cells Ca (C11 to C14, C31 to C34) not supplied with the reset voltage and the second image signal read out from the pixel cells Ca (C21 to C24, C41 to C44) supplied with the reset voltage. According to such control on the solid-state imaging element 10, the pixel cell supplied with the reset voltage and the pixel cell not supplied with the reset voltage can be separately output. The different image information is compared to check whether the afterimage is generated. Even if the afterimage is generated, an image in which the generated afterimage is erased can be generated by generating the interpolated image using the image information acquired under different conditions.

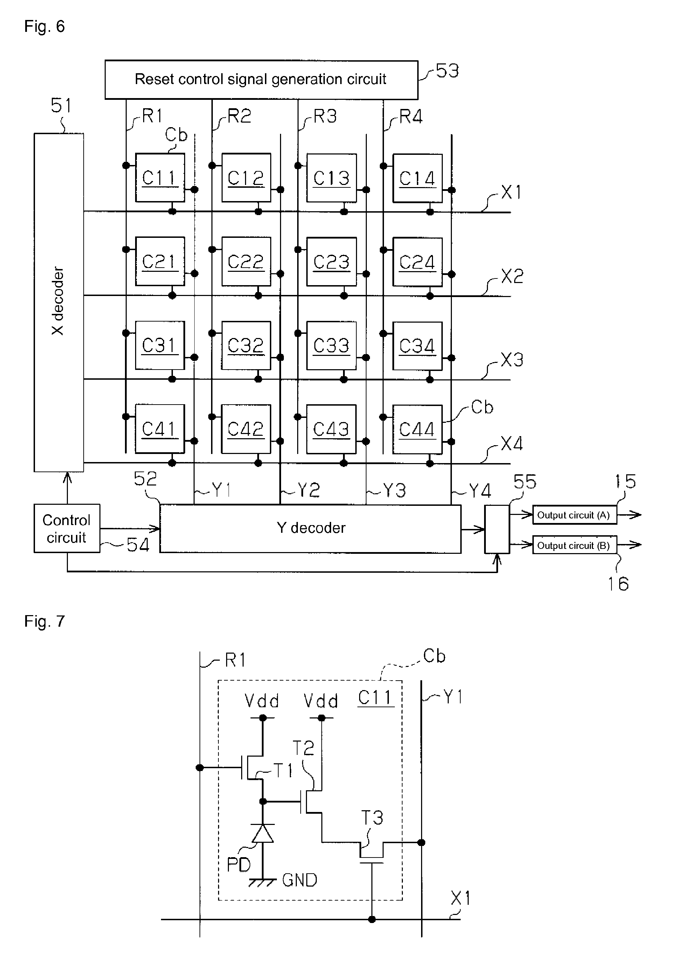

The embodiment may be performed in the following modes.
In the embodiment, the reset voltage is supplied for every row, but the reset voltage may be supplied for every column. For instance, the solid-state imaging element may be configured as shown in FIG. 6. Such solid-state imaging element is separately arranged with an X decoder 51 for selecting the row signal lines X1 to X4 and supplying the read out voltage to the pixel cells Cb; and a reset control signal generation circuit 53 for generating a reset voltage for generating a reset voltage to be supplied to the pixel cell Cb. The reset control signal generation circuit 53 supplies the reset voltage to the pixel cell Cb via every other (e.g., even column) reset voltage lines R2, R4. In the embodiment, the X decoder 12 may be configured by the X decoder 51 and the reset control signal generation circuit 53, as shown in FIG. 6.

When configuring the imaging device in the mode shown in FIG. 6, each pixel cell Cb may have a circuit configuration shown in FIG. 7 by way of example. The connecting destination of the reset voltage line R2 is changed from the X decoder 51 to the reset control signal generation circuit 53. Thus, the reset voltages V6b, V8b are applied to the pixel cells Cb in the row direction.

Each column data line Y1 to Y4 is connected to one Y decoder 52. The Y decoder 52 outputs the image signal converted from the image information input via each column data line Y1 to Y4 to the selecting circuit 55. In response to the control signal input from the control circuit 54, the selecting circuit 55 outputs the image signal based on the image information read out from the pixel cell not supplied with the reset voltage, that is, the pixel cells Cb (C11 to C41, C13 to C43) of odd columns to the output circuit 15 as a first image signal. In response to the control signal, the selecting circuit 55 also outputs the image signal based on the image information read out from the pixel cells supplied with the reset voltage, that is, the pixel cells Cb (C12 to C42, C14 to C44) of even columns to the output circuit 16 as a second image signal.

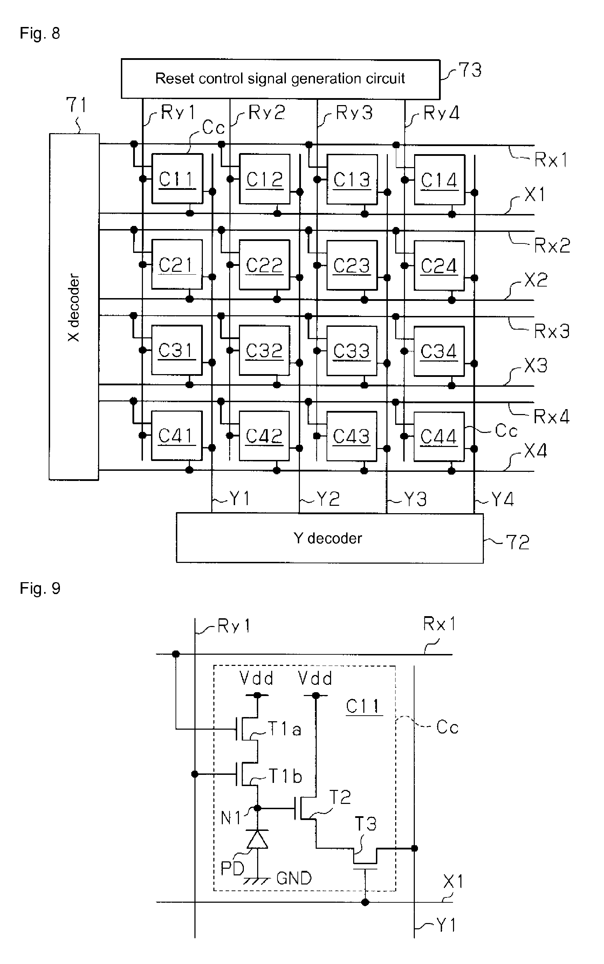

Configuration may be such that the reset voltage is applied in the column direction or the row direction. For instance, the solid-state imaging element may be configured as shown in FIG. 8. In FIG. 8, the operations of an X decoder 71 and a Y decoder 72 are not different from the previously described operations, and thus the description will be omitted. The reset control signal selects either the column direction or the row direction to apply the reset voltage. The reset voltage is applied to the pixel cells Cc in the selected row data line (e.g., pixel cell arrangement C11 to C41) or the pixel cells Cc in the column data line (e.g., pixel cell arrangement C11 to C14) to reset the selected pixel column or the pixel row.

In this case, each pixel cell Cc is configured by a photodiode PD serving as a light receiving element, and four transistors T1 a, T1 b, T2, T3, as shown in FIG. 9. The transistors T1 a, T1 b, T2, T3 are transistors of a first conductivity channel type, and although not shown, the back gates of each MOS transistor are all connected to the ground GND. Similar to the present embodiment, description is made using the N-channel MOS transistor.

The drain (first terminal) of the transistor T1 a serving as a load transistor is supplied with the high potential power supply Vdd, the gate (control terminal) is connected to the reset voltage line Rx1 in the column direction, and the source (second terminal) is connected to the drain of the transistor T1 b.
The gate of the transistor T1 b is connected to the reset voltage line Ry1 in the row direction, and the source is connected to the cathode of the photodiode PD. The anode of the photodiode PD is connected to the low potential power supply (ground GND in the present embodiment). The photodiode PD flows a current lp corresponding to the light quantity of the incident light.

The gate of the transistor T2 serving as the amplifier transistor is connected to a sense node N1, which is a connecting point of the transistor T1b and the photodiode PD. The drain of the transistor T2 is supplied with the high potential power supply Vdd, and the source is connected to the first terminal (e.g., drain) of the transistor T3 serving as the pixel selecting transistor.

The gate of the transistor T3 is connected to the row signal line X1, and the second terminal (source) thereof is connected to the column data line Y1. The transistor T3 is ON/OFF operated in response to the read-out signal provided via the row signal line X1, and connects or separates the second transistor T2 and the column data line Y1. The transistor T2 and the column data line Y1 are connected when the transistor T3 is turned ON. A constant current power supply (not shown) is connected to the column data line Y1. The constant current source configures a source follower circuit with the transistor T2, and the potential of the sense node N1 is output to the column data line Y1 as a photoelectric conversion signal via the transistor T2. According to such configuration, reset is performed only on a specific column or a specific row.

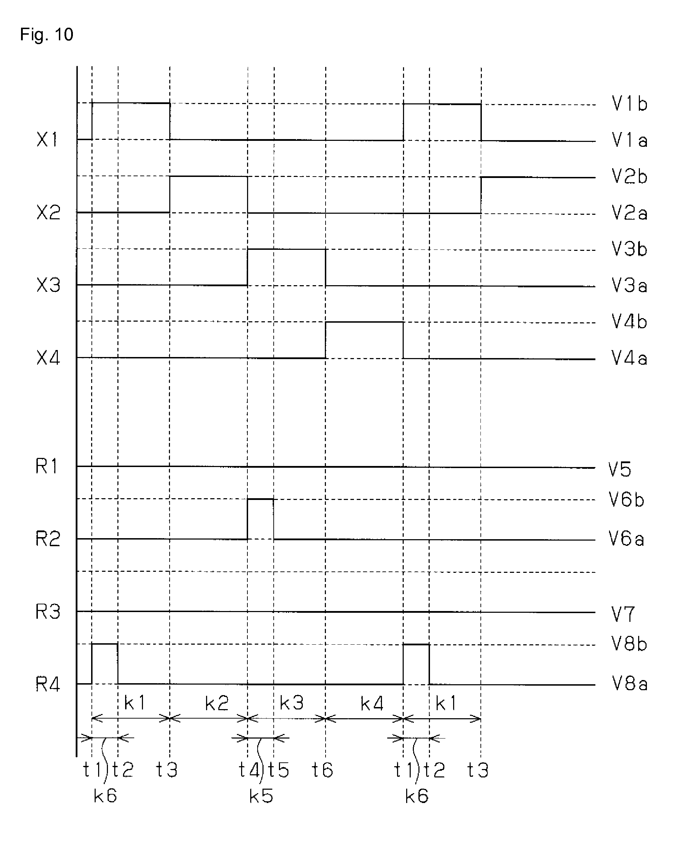

In the embodiment, the potential of the reset voltage has been explained as being the potential higher than 3.3V, which is the normal exposure potential, and returning to 3.3V after the reset operation in the reset periods k5, k6. However, a potential such as 0V lower than the normal exposure potential may be applied as in V6a, v8a after the reset operation in the reset periods k5, k6 for applying the potentials V6b, V8b (both are potentials higher than 3.3V), as shown in FIG. 10.

When 0V is applied as the reset voltage, the first transistor T1 in FIG. 2 is completely turned OFF. Thus, the accumulated potential completely disappears, and the output signal obtained by linear converting the optical signal is obtained from the relevant pixel cells. In the linear conversion, the dynamic range is narrower than in the logarithmic conversion, but a signal in which the precision per one bit is high can be obtained as logarithmic compression is not performed.

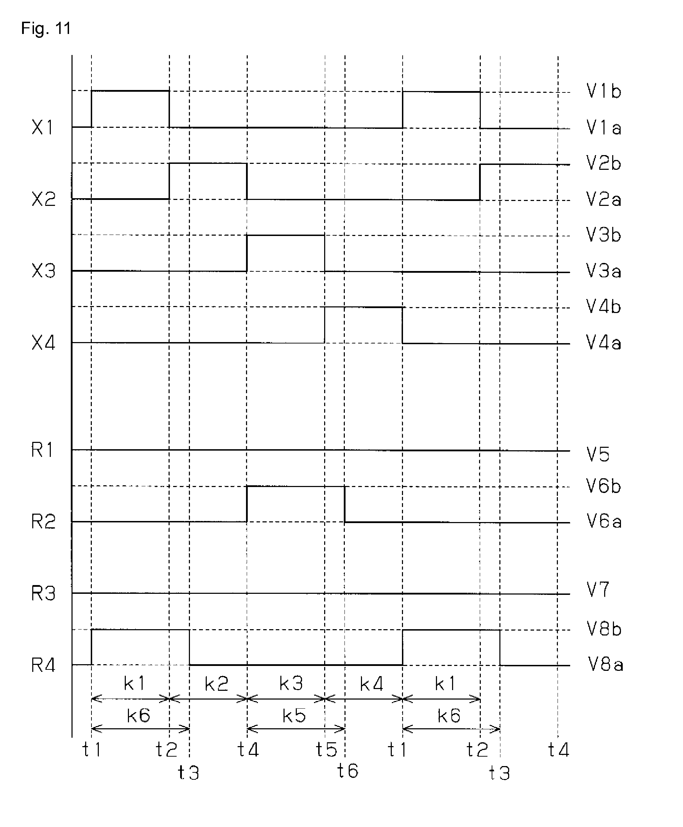

The reset period in the embodiment may be changed. For instance, the length of the reset periods k5, k6 for applying the reset voltage adopted in the embodiment may be instantaneous or may be long periods of an extent not overlapping the next exposure start time t1, as shown in FIG. 11. The integration time can be changed as necessary by carrying out circuit configuration so that the reset period can be controlled. Therefore, the integration time can be adjusted so that the output does not saturate even if the luminance of the subject is high. In this case as well, the potentials V6a, V8a after the reset may be 0V as long as such potentials have values lower than 3.3V.

In the embodiment, the reset method has been described using a rolling shutter method of sequentially shifting the reset timing by rows by way of example, but may be a global shutter method of resetting all the rows at the same timing. Either reset timing may be adopted not only to perform resetting by rows, but also by columns, by partial rows or columns, or to alternately reset either the rows or the columns.

In the embodiment, each pixel cell Ca is selected based on the serial converted address signal Si, but each pixel cell Ca may be selected through other methods. For instance, the clock signal may be input and the pixel cell Ca of each column and each row may be sequentially selected based on the clock signal.

In each embodiment, the reset voltage is supplied to the pixel cell Ca of even row (even column), but the reset voltage may be supplied to the pixel cell Ca of odd row (odd column). The reset voltage may also be supplied alternately to the odd row (odd column) and the even row (even column). The row (column) to be supplied with the reset voltage may be selectable.

In the embodiment, the presence of afterimage caused by the movement of an object having high luminance is determined in all the pixel cells of the imaging unit 11, but the presence of afterimage may be determined at one part thereof. As shown in FIG .12, an imaging unit 81 is configured by a first imaging part 83 having the reset voltage set for every row or every column, and a second imaging part 82 that does not supply the reset voltage to all the pixel cells. According to such configuration, the afterimage from the object imaged in the region imaged by the first imaging part 83 can be erased and the object at the relevant region can be easily determined.

Four by four pixels are used in the imaging unit but may be five by five, 100 by 100, or the like. The number of rows and the number of columns may also differ.
The arrangement of the X decoder, the Y decoders, as well as the control signal lines, the reset voltage signal lines, and the like may be mutually interchanged in view of the connection.

## Claims

1. A solid-state imaging element comprising:
a solid-state imaging element including,
an imaging unit in which a pixel cell including a light receiving element and an element for converting a photocurrent flowing to the light receiving element to a voltage under an electrically equilibrium state is arrayed in a matrix form,
a voltage generating device for generating a reset voltage for resetting the pixel cell, and
a voltage supplying device for supplying the reset voltage to the pixel cell for every predetermined number along at least one of a row direction or a column direction in a reset period; and
an output device for separately outputting a first image signal read out from a pixel cell not supplied with the reset voltage and a second image signal read out from a pixel cell supplied with the reset voltage.

2. An imaging device comprising:
the solid-state imaging element according to claim 1;
an afterimage determining device for determining whether or not an afterimage is generated in an imaged image based on the first image signal and the second image signal output from the output device; and
an afterimage erasing device for erasing the afterimage based on the determination result of the afterimage determining device, the first image signal, and the second image signal.

3. The imaging device according to claim 2, wherein
the afterimage determining device includes contour extracting units for extracting a contour of an imaged image by the first image signal and a contour of an imaged image by the second signal, and a contour comparing unit for comparing the two contours extracted by the contour extracting units, and determines whether or not an afterimage is generated from the comparison result.

4. The imaging device according to claim 2, wherein
the afterimage erasing device includes:
an interpolation device for generating an interpolated image in which an image signal corresponding to the pixel cell not supplied with the reset voltage is interpolated based on the second image signal;
an image synthesizing device for generating a synthesized image by synthesizing the imaged image by the first image signal and the imaged image by the second image signal; and
an output selecting device for outputting the interpolated image generated by the interpolation device when determined that the afterimage is generated in the afterimage determining device, and outputting the synthesized image generated by the synthesizing device when determined that the afterimage is not generated.

5. The imaging device according to claim 2, further comprising an image synthesizing device for generating a synthesized image by synthesizing the first image signal and the second image signal.

6. The imaging device according to claim 2, further comprising an interpolation device for generating an interpolated image in which an image signal corresponding to the pixel cell not supplied with the reset voltage is interpolated based on the second image signal.

7. A method of controlling a solid-state imaging element including an imaging unit in which a plurality of pixel cells is arrayed in a matrix form, each pixel cell having a light receiving element and a MOS transistor connected in series, and converting a photocurrent flowing to the light receiving element according to an incident light by operating the MOS transistor in a weak inversion state to a voltage; the method comprising:
voltage supplying step for supplying a reset voltage for resetting the pixel cell to the pixel cell for every predetermined number along at least one of row direction or column direction in a reset period; and
outputting step for separately outputting a first image signal read out from a pixel cell not supplied with the reset voltage and a second image signal read output from a pixel cell supplied with the reset voltage.
